# EUROPEAN PATENT APPLICATION

(11) **EP 2 922 111 A1**
(43) Date of publication of application: **23.09.2015**
(21) Application number: 14186260.7
(22) Date of filing: 24.09.2014
(51) Int. Cl.: H01L 51/52, H01L 27/32

(54) **ORGANIC LIGHT EMITTING DIODE DISPLAY**

(30) Priority: 18.03.2014 KR 20140031852
(71) Applicant: Samsung Display Co., Ltd., Gyeonggi-Do (KR)
(72) Inventor: Oh, Jae Hwan, Chungcheongnam-do (KR); Noh, Hwa Jin, Gyeonggi-do (KR); Park, Se Hun, Chungcheongnam-do (KR); Lee, Won Kyu, Seoul (KR); Chang, Young Jin, Gyeonggi-do (KR)
(74) Representative: Mounteney, Simon James

(57) **Abstract**

An organic light emitting diode display includes a substrate (110); a gate wire on the substrate; an interlayer insulating layer (160) covering the gate wire; a data wire (171) on the interlayer insulating layer; a passivation layer (180) on the data wire and the interlayer insulating layer and having a protection opening (181); a pixel electrode (191) on a first wiring portion of the data wire exposed through the protection opening and the interlayer insulating layer; a pixel definition layer (350) on the passivation layer and having a pixel opening (351) exposing the pixel electrode; an organic emission layer (370) covering the pixel electrode; and a common electrode (270) covering the organic emission layer and the pixel definition layer, wherein the pixel electrode contacting the first wiring portion of the data wire and the interlayer insulating layer has protrusions and depressions.

## Description

### BACKGROUND

### 1. Field

The described technology relates generally to an organic light emitting diode display.

### 2. Description of the Related Art

An organic light emitting diode display includes two electrodes of an anode and a cathode, and an organic light emitting layer located between the two electrodes. The anode injects holes and the cathode injects electrons into the light emitting layer. The injected electrons and holes are combined to form excitons and the excitons emit light as they discharge energy.

Such an organic light emitting diode display includes a plurality of pixels including an organic light emitting diode, which is a self-emission device, wherein a plurality of thin film transistors and storage capacitors for driving the organic light emitting diode are located in each pixel.

To improve a viewing angle of the organic light emitting diode display, protrusions and depressions are formed at a passivation layer made of an organic layer. Also, for application to a larger TV, in the large organic light emitting diode display, a thickness of the passivation layer is increased to minimize parasitic capacitance between the data wire and the cathode.

However, when forming the protrusions and depressions at the thick passivation layer of the large organic light emitting diode display, by applying a half tone photomask to a pad portion, the protrusions and depressions are formed and simultaneously the thickness of the passivation layer must be reduced in the pad portion to perform pad bonding. Alternatively, a separate mask from the mask to form the pad portion must be added to form the protrusions and depressions in the passivation layer of the pixel.

The above information disclosed in this Background section is only for enhancement of understanding of the background of the described technology and therefore it may contain information that does not form the prior art that is already in this country to a person of ordinary skill in the art.

### SUMMARY

The embodiment provides a large organic light emitting diode display with an improved viewing angle that is produced without an additional mask.

An organic light emitting diode display according to an embodiment includes: a substrate; a gate wire formed on the substrate; an interlayer insulating layer covering the gate wire; a data wire formed on the interlayer insulating layer; a passivation layer formed on the data wire and the interlayer insulating layer and having a protection opening; a pixel electrode formed on a first wiring portion of the data wire exposed through the protection opening and the interlayer insulating layer; a pixel definition layer formed on the passivation layer and having a pixel opening exposing the pixel electrode; an organic emission layer covering the pixel electrode; and a common electrode covering the organic emission layer and the pixel definition layer, wherein the pixel electrode contacting the first wiring portion of the data wire and the interlayer insulating layer has protrusions and depressions.

The pixel electrode may include a convex pixel portion contacting the first wiring portion of the data wire and a concave pixel portion contacting the interlayer insulating layer.

The data wire may further include a dummy data member insulated from the data line, and the first wiring portion of the data wire may include the dummy data member.

The data wire may further include a dummy data member insulated from the data line, and the first wiring portion of the data wire may include the dummy data member.

An auxiliary electrode formed on the passivation layer and separated from the pixel electrode may be further included, and the auxiliary electrode may contact the common electrode.

The pixel definition layer may have an assistance opening exposing the auxiliary electrode, and the common electrode may contact the auxiliary electrode through the assistance opening.

The data wire may include a second wiring portion insulated from the data line, and the auxiliary electrode may be connected to the second wiring portion of the data wire through the contact hole formed in the passivation layer.

The auxiliary electrode may be formed of the same material as the pixel electrode.

The gate wire may include a first storage electrode overlapping the second wiring portion of the data wire, and the second wiring portion of the data wire may be a second storage electrode.

The data wire may further include: a driving voltage line transmitting a driving voltage, a compensation control line transmitting a compensation control signal and crossing the scan line, an operation control line crossing the scan line and transmitting an operation control signal, and a reset control line crossing the scan line and transmitting a reset signal; and the first wiring portion of the data wire may include at least one of the driving voltage line, the compensation control line, the operation control line, and the reset control line.

An auxiliary electrode formed on the passivation layer and separated from the pixel electrode may be further included, and the auxiliary electrode may contact the common electrode.

The auxiliary electrode may overlap the driving voltage line, and the auxiliary electrode may be formed of the same material as the pixel electrode.

The gate wire may further include a scan line transmitting a scan signal, and a switching thin film transistor connected to the scan line and the data line, a compensation thin film transistor connected to the compensation control line, an operation control thin film transistor connected to the operation control line and the switching thin film transistor, and a driving thin film transistor connected to the driving voltage line may be further included.

According to the embodiment, the pixel electrode contacts the first wiring portion of the data wire to form the protrusions and depressions at the pixel electrode such that the viewing angle may be improved.

Also, the viewing angle may be improved without the additional mask such that the manufacturing cost may be reduced and the manufacturing time may be reduced.

Further, the thickness of the first wiring portion of the data wire is increased to increase the angle of the protrusions and depressions of the pixel electrode such that the viewing angle may be further improved.

### BRIEF DESCRIPTION OF THE DRAWINGS

FIG. 1 is a cross-sectional view of an organic light emitting diode display according to an embodiment.
FIG. 2 is an equivalent circuit diagram of one pixel of an organic light emitting diode display according to another embodiment.
FIG. 3 is a view schematically showing a position of a plurality of thin film transistors and capacitors in three pixels of an organic light emitting diode display according to another embodiment.
FIG. 4 is a detailed layout view of one pixel of an organic light emitting diode display according to another embodiment.
FIG. 5 is a cross-sectional view of the organic light emitting diode display FIG. 3 taken along a line V-V.
FIG. 6 is a cross-sectional view of an organic light emitting diode display according to another embodiment.
FIG. 7 is a cross-sectional view of an organic light emitting diode display according to another embodiment.

### DETAILED DESCRIPTION

The embodiments will be described more fully hereinafter with reference to the accompanying drawings, in which embodiments of the invention are shown. As those skilled in the art would realize, the described embodiments may be modified in various different ways, all without departing from the scope of the present invention as defined in the claims.

The drawings and description are to be regarded as illustrative in nature and not restrictive. Like reference numerals designate like elements throughout the specification.

Further, since sizes and thicknesses of constituent members shown in the accompanying drawings are arbitrarily given for better understanding and ease of description, the present invention is not limited thereto.

In the drawings, the thickness of layers, films, panels, regions, etc., are exaggerated for clarity. In the drawings, for better understanding and ease of description, the thicknesses of some layers and areas are exaggerated. It will be understood that when an element such as a layer, film, region, or substrate is referred to as being "on" another element, it can be directly on the other element or intervening elements may also be present.

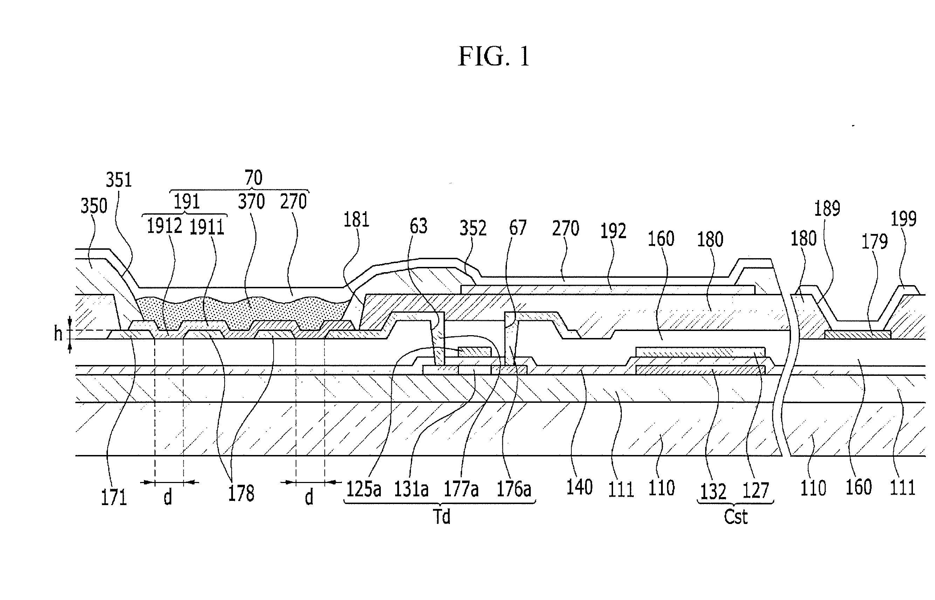

An organic light emitting diode display according to an embodiment will be described with reference to FIG. 1.

FIG. 1 is a cross-sectional view of an organic light emitting diode display according to an embodiment.

As shown in FIG. 1, in the organic light emitting diode display according to an embodiment, a buffer layer 111 is formed on a substrate 110, and a driving semiconductor layer 131 a and a first storage electrode 132 forming a storage capacitor Cst are formed on the buffer layer 111. The substrate 110 may include an insulation substrate made of glass, quartz, a ceramic material, or a plastic material.

A gate insulating layer 140 made of a silicon nitride (SiNx) or a silicon oxide (SiOₓ) is formed on the driving semiconductor layer 131 a and the first storage electrode 132.

A gate wire including a driving gate electrode 125a and a second storage electrode 127 is formed on the gate insulating layer 140. The storage capacitor Cst includes the first storage electrode 132 and the second storage electrode 127 disposed via the gate insulating layer 140 located therebetween. In one embodiment, the gate insulating layer 140 becomes a dielectric material, and a storage capacitance is determined by a charge charged to the storage capacitor Cst and a voltage between both electrodes 132 and 127.

An interlayer insulating layer 160 covering the driving gate electrode 125a and the second storage electrode 127 is formed on the gate insulating layer 140. The gate insulating layer 140 and the interlayer insulating layer 160 together have a contact hole 63 exposing a drain region of the driving semiconductor layer 131a. The interlayer insulating layer 160 is made by using a ceramic-based material such as a silicon nitride (SiNx) or a silicon oxide (SiOₓ), like the gate insulating layer 140.

A data wire including a data line 171, a driving source electrode 176a, a driving drain electrode 177a, a dummy data member 178, and a data pad portion 179 is formed on the interlayer insulating layer 160. In this case, the driving source electrode 176a and the driving drain electrode 177a are respectively connected to a source region and a drain region of the driving semiconductor layer 131a through contact holes 67 and 63 formed in the interlayer insulating layer 160 and the gate insulating layer 140. The driving thin film transistor Td includes the driving semiconductor layer 131a, the driving gate electrode 125a, the driving source electrode 176a, and the driving drain electrode 177a.

A passivation layer 180 is formed on the interlayer insulating layer 160, and the passivation layer 180 has a protection opening 181. Among the data wire portions 171, 176a, 177a, 178, and 179, the first wiring portions 171 and 178 are exposed through the protection opening 181. The first wiring portions 171 and 178 exposed through the protection opening 181 may include the data line 171 transmitting a data signal and the dummy data member 178 insulated from the data line 171. The data line 171 and the dummy data member 178 are separated from each other by an interval d, and expose the interlayer insulating layer 160 through the interval d.

A pixel electrode 191 is formed on the first wiring portions 171 and 178 exposed by the protection opening 181 and the interlayer insulating layer 160. The pixel electrode 191 contacting the first wiring portions 171 and 178 and the interlayer insulating layer 160 has a protrusions and depressions (i.e., it has a contoured or uneven surface). The pixel electrode 191 includes a convex pixel portion 1911 contacting the first wiring portions 171 and 178, and a concave pixel portion 1912 contacting the interlayer insulating layer 160. The concave pixel portion 1912 contacts the interlayer insulating layer 160 and the convex pixel portion 1911 is positioned to be higher than (i.e., not coplanar with) the concave pixel portion 1912 by a thickness h of the first wiring portions 171 and 178, and thereby the pixel electrode 191 has the protrusions and depressions.

A pixel definition layer 350 having a pixel opening 351 exposing the pixel electrode 191 is formed on the passivation layer 180. An organic emission layer 370 is formed on the pixel electrode 191 exposed through the pixel opening 351, and a common electrode 270 is formed on the organic emission layer 370 and the pixel definition layer. Accordingly, an organic light emitting diode 70 including the pixel electrode 191, the organic emission layer 370, and the common electrode 270 is formed.

In one embodiment, the pixel electrode 191 may be formed of a metal having high reflectance, and the common electrode 270 may be made of a transparent conductor such as ITO or IZO for top emission. The pixel electrode 191 is an anode as a hole injection electrode, and the common electrode 270 is a cathode as an electron injection electrode. However, an embodiment according to the present invention is not limited thereto, and according to a driving method of the organic light emitting diode display, the pixel electrode 191 may be the cathode and the common electrode 270 may be the anode. The hole and the electron are injected into the organic emission layer 370 from the pixel electrode 191 and the common electrode 270, respectively, and an exciton generated by coupling the injected hole and electron falls from an excited state to a ground state to emit light.

As described above, the pixel electrode contacts the first wiring portion to form the protrusions and depressions in the pixel electrode, and thereby the emitted light generates the diffused reflection on the protrusions and depressions of the pixel electrode such that the viewing angle may be improved.

Also, by increasing the thickness of the first wiring portion, an angle of the protrusions and depressions of the pixel electrode is increased such that the viewing angle may be further improved.

Further, the protrusions and depressions are not formed at the surface of the passivation layer to improve the viewing angle such that a separate mask to form the protrusions and depressions at the passivation layer may be omitted, thereby reducing manufacturing cost and manufacturing time.

In one embodiment, an auxiliary electrode 192 may be formed at a position separated from the pixel electrode 191 on the passivation layer 180. The pixel definition layer 350 has an assistance opening 352 exposing the auxiliary electrode 192, and the auxiliary electrode 192 contacts the common electrode 270 through the assistance opening 352.

When the organic light emitting diode display is applied to a large TV, the common electrode 270 is also typically large. Thereby a stain may be easily generated by a voltage drop in the large common electrode 270. Accordingly, to prevent the voltage drop of the common electrode 270, the common electrode 270 contacts the auxiliary electrode 192 made of a lower resistance material and a current also flows to the auxiliary electrode 192, thereby reducing the resistance.

The passivation layer 180 has a pad opening 189 exposing the data pad 179, and an assistance pad 199 made of the same material as the pixel electrode 191 is formed on the data pad 179 to protect the data pad 179.

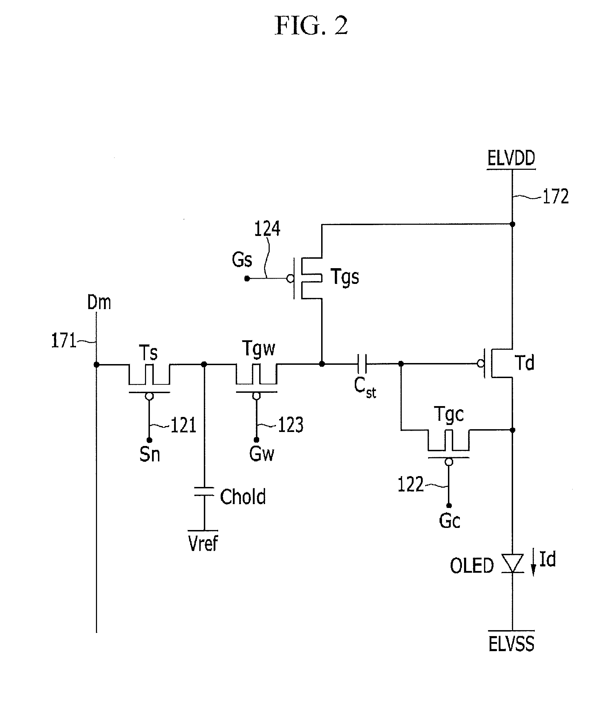

Another embodiment of applying the pixel electrode having the protrusions and depressions to an organic light emitting diode display having a compensation circuit is possible. An organic light emitting diode display according to another embodiment will be described with reference to FIG. 2 to FIG. 6.

FIG. 2 is an equivalent circuit diagram of one pixel of an organic light emitting diode display according to another embodiment.

As shown in FIG. 2, one pixel of the organic light emitting diode display according to another embodiment includes a plurality of signal lines 121, 122, 123, 124, 171, and 172, a plurality of thin film transistors Td, Ts, Tgc, Tgs, and Tgw connected to a plurality of signal lines, a plurality of capacitors Cst and Chold, and an organic light emitting diode (OLED).

The plurality of thin film transistors includes a driving thin film transistor Td, a switching thin film transistor Ts, a compensation thin film transistor Tgc, a reset thin film transistor Tgs, and an operation control thin film transistor Tgw, and the plurality of capacitors Cst and Chold includes a storage capacitor Cst and a hold capacitor Chold.

The signal lines include a scan line 121 transmitting a scan signal Sn, a compensation control line 122 transmitting a compensation control signal Gc to a compensation thin film transistor Tgc, an operation control line 123 transmitting an operation control signal Gw to an operation control thin film transistor Tgw, a reset control line 124 transmitting a reset signal Gs to a reset thin film transistor Tgs, a data line 171 crossing the scan line 121 and transmitting a data signal Dm, and a driving voltage line 172 transmitting a driving voltage ELVDD to the driving thin film transistor Td.

The driving thin film transistor Td includes a gate electrode connected to one terminal of the storage capacitor Cst, a source electrode connected to the driving voltage line 172, and a drain electrode electrically connected to the organic light emitting diode (OLED).

The gate electrode of the switching thin film transistor Ts is connected to the scan line 121, the source electrode of the switching thin film transistor Ts is connected to the data line 171, the drain electrode of the switching thin film transistor Ts is connected to the other terminal of the holding capacitor Chold and the source electrode of the operation control thin film transistor Tgw. The switching thin film transistor Ts is turned on according to the scan signal Sn transferred through the scan line 121, and a scanning operation where the data signal Dm transferred from the data line 171 is programmed in the holding capacitor Chold is performed.

The gate electrode of the operation control thin film transistor Tgw is connected to the operation control line 123, the source electrode of the operation control thin film transistor Tgw is connected to the other end of the hold capacitor Chold and the drain electrode of the switching thin film transistor Ts, and the drain electrode of the operation control thin film transistor Tgw is connected to the drain electrode of the reset thin film transistor Tgs and the other terminal storage capacitor Cst.

The operation control thin film transistor Tgw is turned off while the organic light emitting diode (OLED) emits light. A data signal is programmed in the hold capacitor Chold during this period. In other words, the operation control thin film transistor Tgw electrically isolates the hold capacitor Chold and the storage capacitor Cst from each other so that the light emission and data programming operations are simultaneously performed.

The reset thin film transistor Tgs has the gate electrode connected to the reset control line 124, the source electrode connected to the driving voltage line 172, and the drain electrode connected to the other terminal of the storage capacitor Cst and the drain electrode of the operation control thin film transistor Tgw. The reset thin film transistor Tgs is turned on according to the reset control signal Gs transmitted through the reset control line 124. Thus, the voltage of the gate electrode of the driving thin film transistor Td is reset through the driving voltage line 172.

The compensation thin film transistor Tgc has the gate electrode connected to the compensation control line 122, the source electrode connected to the drain electrode of the driving thin film transistor Td and the anode of the organic light emitting diode(OLED), and the drain electrode connected to one terminal of the storage capacitor Cst. The compensation thin film transistor Tgc is turned on according to the compensation control signal Gc transmitted through the compensation control line 122 such that the gate electrode and the drain electrode of the driving thin film transistor Td are connected, thereby diode-connecting the driving thin film transistor Td.

The data voltage transferred through the turned on switching thin film transistor Ts while a scanning period of an i-th frame is programmed in the hold capacitor Chold. The operation control thin film transistor Tgw is turned on during a period from a time at which the light emitting period of the i-th frame is finished to a time at which the (i+1)-th light emitting period starts, and the data signal stored in the hold capacitor Chold is transferred to the storage capacitor Cst during a turn-on period.

An end of the storage capacitor Cst is connected to the driving voltage line 172, and a gate-source voltage of the driving transistor Td is determined according to the voltage programmed to the storage capacitor Cst. The cathode of the organic light emitting diode (OLED) is connected to a common voltage ELVSS.

The organic light emitting diode (OLED) emits light according to a driving current Id transferred from the driving voltage ELVDD through the driving thin film transistor Td, and the driving current Id flows as a common voltage ELVSS.

As described above, the organic light emitting diode display according to the embodiment is operated according to a driving method where a plurality of pixels simultaneously emit light during a present frame period according to the data voltage programmed in a prior frame and present frame data are simultaneously programmed in a plurality of pixels.

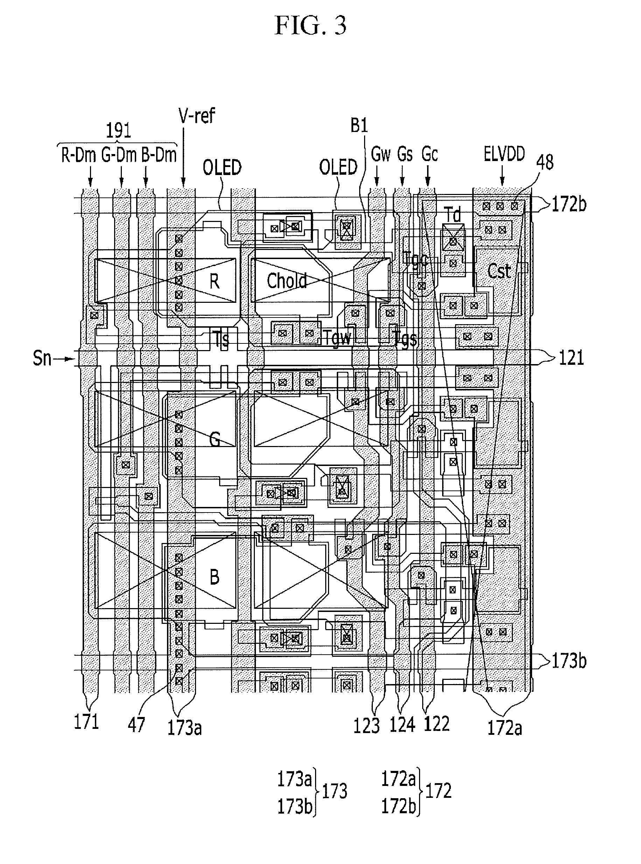

Now, a detailed structure of the pixel of the organic light emitting diode display shown in FIG. 2 will be described in detail with reference to FIG. 3 to FIG. 6 together with FIG. 2.

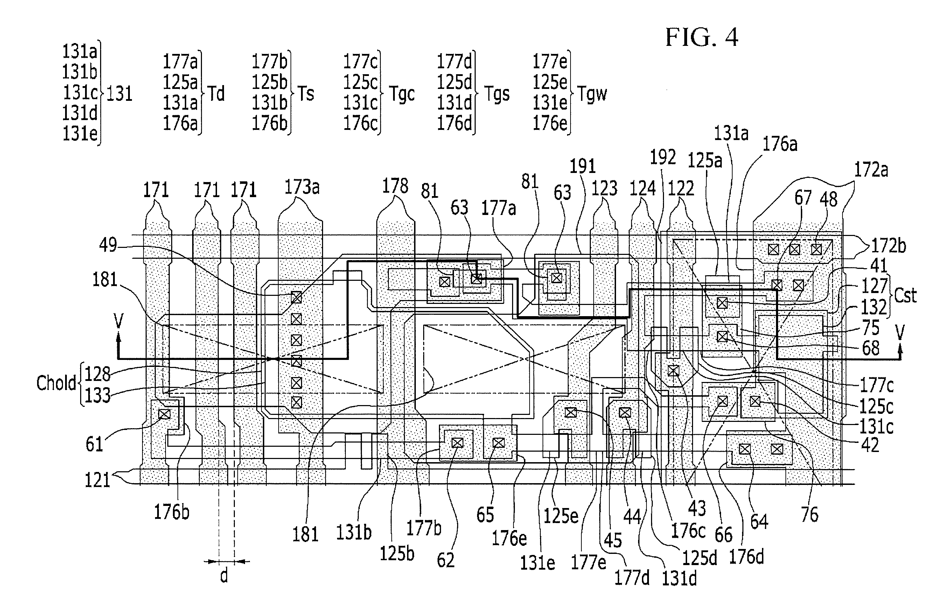

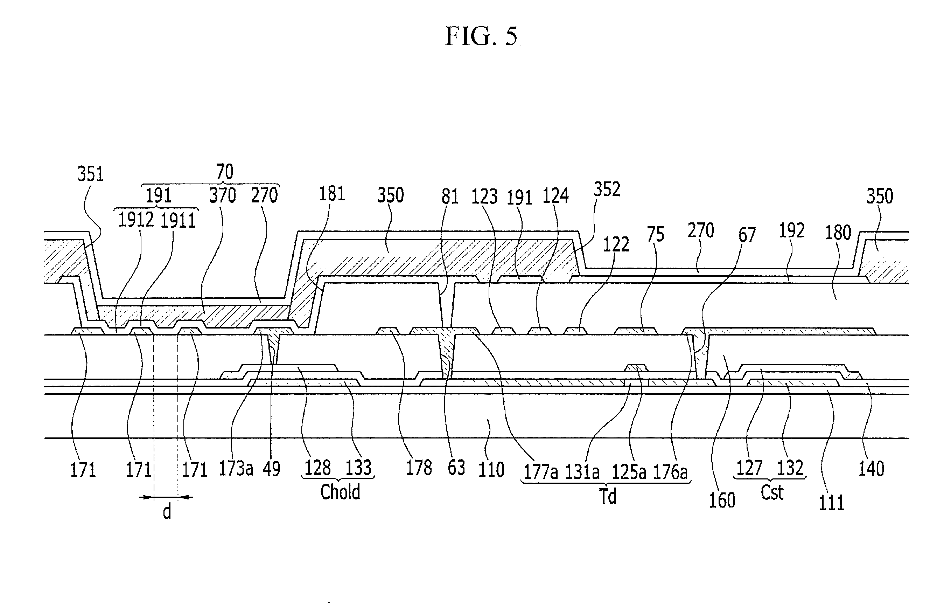

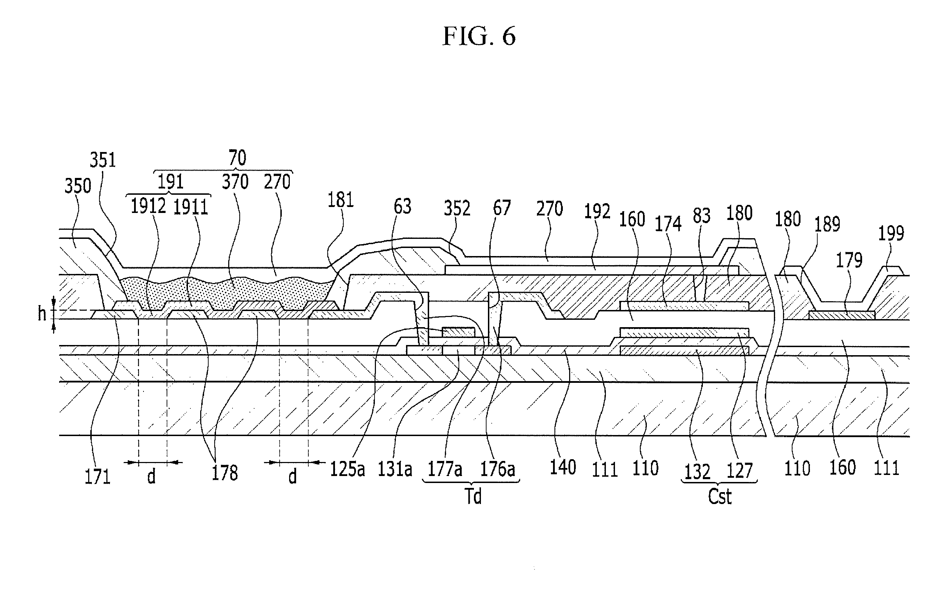

FIG. 3 is a view schematically showing a position of a plurality of thin film transistors and capacitors in three pixels of an organic light emitting diode display according to another embodiment, FIG. 4 is a detailed layout view of one pixel of an organic light emitting diode display according to another embodiment, FIG. 5 is a cross-sectional view of the organic light emitting diode display of FIG. 4 taken along a line V-V, and FIG. 6 is a cross-sectional view of an organic light emitting diode display according to another embodiment.

As shown in FIG. 2 to FIG. 5, the pixel of the organic light emitting diode display according to the current embodiment includes the scan line 121 transmitting the scan signal Sn and formed in a row direction, the compensation control line 122 crossing the scan line 121, transmitting the compensation control signal Gc, and formed in a column direction, the operation control line 123 crossing the scan line 121, transmitting the operation control signal Gw, and formed in the column direction, the reset control line 124 crossing the scan line 121, transmitting the reset control signal Gs, and formed in the column direction, the data line 171 and the driving voltage line 172 crossing the scan line 121 and respectively transmitting the data signal Dm and the driving voltage ELVDD to the pixel, and the reference voltage line 173 crossing the scan line 121 and transmitting the reference voltage Vref to the pixel.

The driving voltage line 172 includes a vertical driving voltage line 172a parallel to the data line 171 and a horizontal driving voltage line 172b connected to and crossing the vertical driving voltage line 172a, and the reference voltage line 173 includes a vertical reference voltage line 173a parallel to the data line 171 and a horizontal reference voltage line 173b connected to and crossing the vertical reference voltage line 173a.

Three data lines 171 respectively transmit data signals R-Dm, G-Dm, and B-Dm to three pixels, that is, a red pixel R, a green pixel G, and a blue pixel B, and the driving voltage lines 172 all transmit the driving voltage ELVDD transmitted to three pixels through the vertical driving voltage line 172a to the pixels adjacent in the row direction by using the horizontal driving voltage line 172b, and the reference voltage line 173 all transmit the reference voltage Vref transmitted to three pixels through the vertical reference voltage line 173a to the pixels adjacent in the row direction through the horizontal reference voltage line 173b.

Also, the pixel includes the driving thin film transistor Td, the switching thin film transistor Ts, the compensation thin film transistor Tgc, the reset thin film transistor Tgs, the operation control thin film transistor Tgw, the storage capacitor Cst, the hold capacitor Chold, and the organic light emitting diode (OLED).

The driving thin film transistor Td, the switching thin film transistor Ts, the compensation thin film transistor Tgc, the reset thin film transistor Tgs, and the operation control thin film transistor Tgw are formed according to the semiconductor layer 131, and the semiconductor layer 131 may be curved in various shapes. In one embodiment, the semiconductor layer 131 is formed of polysilicon, and includes a channel region not doped with an impurity and a source region and a drain region formed at both sides of the channel region to be doped with the impurity. In embodiments, the impurity is changed according to a kind of thin film transistor, and an N type impurity or a P type impurity is feasible. The semiconductor layer includes a driving semiconductor layer 131 a formed on the driving thin film transistor Td, a switching semiconductor layer 131b formed on the switching thin film transistor Ts, a compensation semiconductor layer 131 c formed on the compensation thin film transistor Tgc, a reset semiconductor layer 131d formed on the reset thin film transistor Tgs, and an operation control semiconductor layer 131 e formed on the operation control thin film transistor Tgw.

The driving thin film transistor Td includes the driving semiconductor layer 131 a, the driving gate electrode 125a, the driving source electrode 176a, and the driving drain electrode 177a.

The switching thin film transistor Ts includes the switching semiconductor layer 131 b, a switching gate electrode 125b, a switching source electrode 176b, and a switching drain electrode 177b.

The compensation thin film transistor Tgc includes the compensation semiconductor layer 131 c, a compensation gate electrode 125c, a compensation source electrode 176c, and a compensation drain electrode 177c, wherein the compensation source electrode 176c corresponds to a compensation source region doped with the impurity in the compensation semiconductor layer 131 c, and the compensation drain electrode 177c corresponds to a compensation drain region doped with the impurity in the compensation semiconductor layer 131c. The compensation gate electrode 125c is connected to the compensation control line 122 through a contact hole 43 formed in the interlayer insulating layer 160.

The reset thin film transistor Tgs includes the reset semiconductor layer 131d, a reset gate electrode 125d, a reset source electrode 176d, and a reset drain electrode 177d, wherein the reset drain electrode 177d corresponds to a reset drain region doped with the impurity in the reset semiconductor layer 131d, and the reset source electrode 176d is connected to the vertical driving voltage line 172a through a contact hole 64 formed in the interlayer insulating layer 160 and the gate insulating layer 140. The reset gate electrode 125d is connected to the reset control line 124 through a contact hole 44 formed in the interlayer insulating layer 160.

The operation control thin film transistor Tgw includes the operation control semiconductor layer 131e, an operation control gate electrode 125e, an operation control source electrode 176e, and an operation control drain electrode 177e, wherein the operation control source electrode 176e corresponds to the operation control source region doped with the impurity in the operation control semiconductor layer 131e. The operation control gate electrode 125e is connected to the operation control line 123 through a contact hole 45 formed in the interlayer insulating layer 160.

The storage capacitor Cst includes the first storage electrode 132 and the second storage electrode 127 disposed via the gate insulating layer 140 located therebetween. In one embodiment, the gate insulating layer 140 is the dielectric material, and the storage capacitance is determined by the charge amount charged to the storage capacitor Cst and the voltage between the two electrodes 132 and 127.

The first storage electrode 132 is formed with the same layer as the driving semiconductor layer 131 a, the switching semiconductor layer 131b, the compensation semiconductor layer 131c, the reset semiconductor layer 131d, and the operation control semiconductor layer 131e, and the second storage electrode 127 is formed with the same layer as the scan line 121.

The first storage electrode 132 is connected to a driving gate connecting member 75 through a contact hole 68 formed in the gate insulating layer 140 and the interlayer insulating layer 160, and the driving gate connecting member 75 is connected to the driving gate electrode 125a through a contact hole 41 formed in the interlayer insulating layer 160.

The second storage electrode 127 is connected to a storage connecting member 76 through a contact hole 42 formed in the interlayer insulating layer 160, and the storage connecting member 76 is connected to the initialization drain electrode 177d and the operation control drain electrode 177e through a contact hole 66 formed in the interlayer insulating layer 160 and the gate insulating layer 140.

The hold capacitor Chold includes a first hold electrode 133 and a second hold electrode 128 disposed via the gate insulating layer 140 located therebetween. The first hold electrode 133 is formed with the same layer as the first storage electrode 132, and the second hold electrode 128 is formed with the same layer as the scan line 121.

The first hold electrode 133 is connected to the operation control source electrode 176e and the switching drain electrode 177b through contact holes 65 and 62 formed in the gate insulating layer 140 and the interlayer insulating layer 160. The second hold electrode 128 is connected to the vertical reference voltage line 173a through a contact hole 49 formed in the interlayer insulating layer 160.

A structure of the organic light emitting diode display device according to another embodiment will be described hereinafter according to a laminating sequence with reference to FIG. 4 and FIG. 5.

In this case, a structure of the thin film transistor will be described with the driving thin film transistor Td as a main part. Further, the residual thin film transistors Ts, Tgc, Tgs, and Tgw are substantially the same as the lamination structure of the driving thin film transistor Td, and thus are not described in further detail.

The buffer layer 111 is formed on the substrate 110, and the driving semiconductor layer 131 a, the first storage electrode 132 forming the storage capacitor Cst, and the first hold electrode 133 forming the hold capacitor Chold are formed on the buffer layer 111.

The gate insulating layer 140 made of a silicon nitride (SiNx) or a silicon oxide (SiOₓ) is formed on the driving semiconductor layer 131 a and the first storage electrode 132.

The gate wire including the scan line 121 including the switching gate electrode 125b, the driving gate electrode 125a, the compensation gate electrode 125c, the reset gate electrode 125d, and the operation control gate electrode 125e is formed on the gate insulating layer 140. The gate wire further includes the second storage electrode 127 forming the storage capacitor Cst, the second hold electrode 128 forming the hold capacitor Chold, the horizontal driving voltage line 172b, and the horizontal reference voltage line 173b.

The interlayer insulating layer 160 covering the driving gate electrode 125a, the second storage electrode 127, and the second hold electrode 128 is formed on the gate insulating layer 140. The gate insulating layer 140 and the interlayer insulating layer 160 together have the contact holes 63 and 67 respectively exposing the drain region and the source region of the driving semiconductor layer 131 a.

A data wire including the data line 171 including the switching source electrode 176b, the switching drain electrode 177b, the vertical driving voltage line 172a, the vertical reference voltage line 173a, the driving source electrode 176a, the driving drain electrode 177a, the compensation control line 122, the operation control line 123, the reset control line 124, and the dummy data member 178 is formed on the interlayer insulating layer 160.

Also, the switching source electrode 176b is connected to the source region of the switching semiconductor layer 131b through a contact hole 61 formed in the interlayer insulating layer 160 and the gate insulating layer 140.

The vertical driving voltage line 172a is connected to the horizontal driving voltage line 172b though a contact hole 48 formed in the interlayer insulating layer 160, and the vertical reference voltage line 173a is connected to the horizontal reference voltage line 173b through a contact hole 47 formed in the interlayer insulating layer 160.

The driving source electrode 176a and the driving drain electrode 177a are respectively connected to the source region and the drain region of the driving semiconductor layer 131a through the contact holes 67 and 63 formed in the interlayer insulating layer 160 and the gate insulating layer.

The passivation layer 180 is formed on the interlayer insulating layer 160, and the passivation layer 180 has the protection opening 181. The first wiring portions 171, 173a, 178, 123, and 124 among the data wires 171, 173a, 176a, 177a, 176b, 177b, 178, 122, 123, 124, and 172a are exposed through the protection opening 181. The first wiring portions 171, 173a, 178, 123, and 124 exposed through the protection opening 181 may include the data line 171 transmitting the data signal, the vertical reference voltage line 173a, the dummy data member 178 insulated from the data line 171, the operation control line 123, and the reset control line 124. The data line 171, the vertical reference voltage line 173a, the dummy data member 178, the operation control line 123, and the reset control line 124 are separated from each other by an interval, and the interlayer insulating layer 160 is exposed through the separated interval d. In this case, the data line 171, the vertical reference voltage line 173a, the dummy data member 178, the operation control line 123, and the reset control line 124 are only exposed through the protection opening 181, however the vertical driving voltage line 172a and the compensation control line 122 may be exposed through the protection opening 181 through the control of the wiring interval and the wiring position.

The pixel electrode 191 is formed on the first wiring portions 171, 173a, 178, 123, and 124 exposed through the protection opening 181 and the interlayer insulating layer 160. The driving drain electrode 177d is connected to the pixel electrode 191 through a contact hole 81 formed in the passivation layer 180. The pixel electrode 191 contacting the first wiring portions 171, 173a, 178, 123, and 124 and the interlayer insulating layer 160 has the protrusions and depressions. The pixel electrode 191 includes the convex pixel portion 1911 contacting the first wiring portions 171, 173a, 178, 123, and 124 and the concave pixel portion 1912 contacting the interlayer insulating layer 160. The concave pixel portion 1912 contacts the interlayer insulating layer 160, and the convex pixel portion 1911 is positioned to be higher than the concave pixel portion 1912 by the thickness h of the first wiring portions 171, 173a, 178, 123, and 124 such that the pixel electrode 191 has the protrusions and depressions.

A pixel definition layer 350 having a pixel opening 351 exposing the pixel electrode 191 is formed on the passivation layer 180. The organic emission layer 370 is formed on the pixel electrode 191 exposed through the pixel opening 351, and the common electrode 270 is formed on the organic emission layer 370 and the pixel definition layer. Accordingly, the organic light emitting diode 70 including the pixel electrode 191, the organic emission layer 370, and the common electrode 270 is formed.

As described above, by contacting the pixel electrode with the first wiring portion to form the protrusions and depressions at the pixel electrode, the emitted light generates diffused reflection on the protrusions and depressions of the pixel electrode, thereby improving the viewing angle. Also, by increasing the thickness of the first wiring portion to increase the angle of the protrusions and depressions of the pixel electrode, the viewing angle may be further improved.

In the embodiment, only the auxiliary electrode minimizes the voltage drop, however another embodiment in which a second wiring portion connected to the auxiliary electrode is formed of the data wire to further minimize the voltage drop is possible.

An organic light emitting diode display according to another embodiment will be described with reference to FIG. 6.

FIG. 6 is a cross-sectional view of an organic light emitting diode display according to another embodiment.

The embodiment of FIG. 6 is substantially the same as the embodiment shown in FIG. 1 except for the second wiring portion, such that the overlapping description is substantially omitted.

As shown in FIG. 6, on the interlayer insulating layer 160 of the organic light emitting diode display according to the current embodiment, the data wire including the data line 171, the assistance data line 174, the driving source electrode 176a, the driving drain electrode 177a, the dummy data member 178, and the data pad 179 is formed.

The passivation layer 180 is formed on the interlayer insulating layer 160, and the passivation layer 180 has the protection opening 181. The first wiring portions 171 and 178 among the data wire portions 171, 174, 176a, 177a, 178, and 179 are exposed through the protection opening 181, and a second wiring portion 174 insulated from the data line 171 among the data wire portions 171, 174, 176a, 177a, 178, and 179 includes an assistance data line 174.

The auxiliary electrode 192 is connected to the assistance data line 174 through a contact hole 83 formed in the passivation layer 180. The assistance data line 174 is made of the low resistance material, and the current flowing to the common electrode flows through both the auxiliary electrode 192 and assistance data line 174 such that the voltage drop of the common electrode may be prevented. Also, an area of the auxiliary electrode 192 may be reduced such that the area occupied by the auxiliary electrode 192 may be reduced, thereby improving the aperture ratio.

In the present embodiment, to further minimize the voltage drop, the second wiring portion connected to the auxiliary electrode is formed, however another embodiment of forming the storage capacitor by using the second wiring portion is possible.

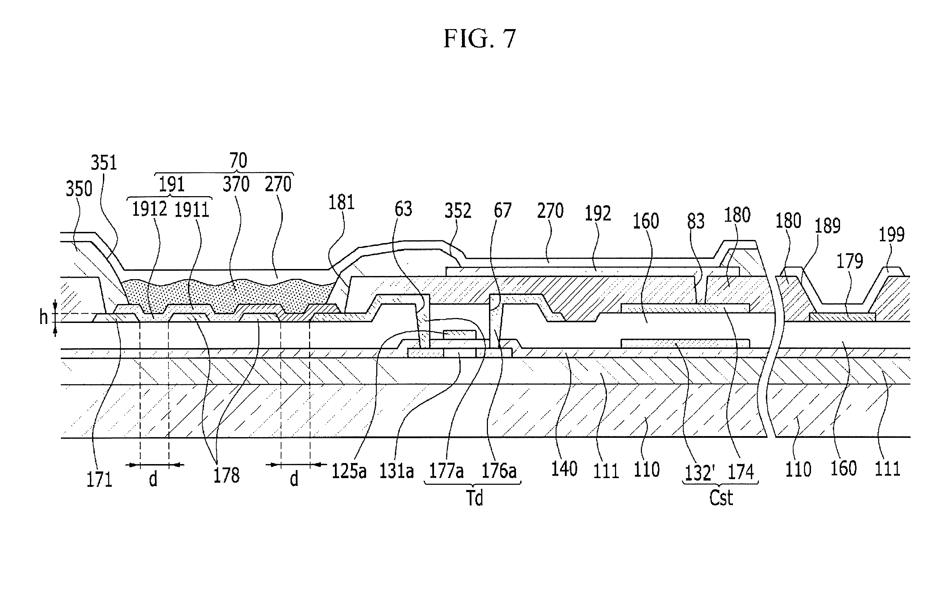

Next, an organic light emitting diode display according to another embodiment will be described with reference to FIG. 7.

FIG. 7 is a cross-sectional view of an organic light emitting diode display according to another embodiment.

The embodiment of FIG. 7 is substantially the same as the embodiment shown in FIG. 6 except for the storage capacitor, such that the overlapping description is substantially omitted.

As shown in FIG. 7, in the organic light emitting diode display according to another embodiment, the buffer layer 111 is formed on the substrate 110, and the driving semiconductor layer 131a is formed on the buffer layer 111.

The gate insulating layer 140 made of a silicon nitride (SiNx) or a silicon oxide (SiOₓ) is formed on the driving semiconductor layer 131a. The gate wire including the driving gate electrode 125a and the first storage electrode 132' is formed on the gate insulating layer 140.

The interlayer insulating layer 160 covering the driving gate electrode 125a and the first storage electrode 132' is formed on the gate insulating layer 140. The data wire including the data line 171, the assistance data line 174, the driving source electrode 176a, the driving drain electrode 177a, the dummy data member 178, and the data pad portion 179 is formed on the interlayer insulating layer 160.

The storage capacitor Cst includes the first storage electrode 132' and the second storage electrode 174 made of the assistance data line 174 overlapping each other via the interlayer insulating layer 160 located therebetween. In one embodiment, the interlayer insulating layer 160 becomes the dielectric material, and the storage capacitance is determined by the charge amount charged to the storage capacitor Cst and the voltage between the two electrodes 127 and 174.

As described above, the first storage electrode is formed of the gate wire by performing the storage doping to the semiconductor layer by using the separate mask without the separate formation of the first storage electrode, thereby reducing the number of masks. Thus, manufacturing time and manufacturing cost can be reduced.

The passivation layer 180 is formed on the interlayer insulating layer 160, and the passivation layer 180 has the protection opening 181. The first wiring portions 171 and 178 among the data wire portions 171, 174, 176a, 177a, 178, and 179 are exposed through the protection opening 181, and the second wiring portion 174 insulated from the data line 171 among the data wire portions 171, 174, 176a, 177a, 178, and 179 includes the assistance data line 174.

The auxiliary electrode 192 is connected to the assistance data line 174 through the contact hole 83 formed in the passivation layer 180. The assistance data line 174 is made of the low resistance material, and the current flowing to the common electrode flows through both the auxiliary electrode 192 and assistance data line 174 such that the voltage drop of the common electrode may be prevented. Also, the area of the auxiliary electrode may be reduced such that the aperture ratio impacted by the auxiliary electrode may be reduced, thereby improving a lifetime of the display.

While this disclosure has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. An organic light emitting diode display comprising:
a substrate (10);
a gate wire (125a, 127) on the substrate;
an interlayer insulating layer (160) covering the gate wire;
a data wire on the interlayer insulating layer (160);
a passivation layer (180) on the data wire and the interlayer insulating layer (160) and having a protection opening (181);
a pixel electrode (191) on a first wiring portion (171, 178) of the data wire exposed through the protection opening (181) and the interlayer insulating layer (160);
a pixel definition layer (350) on the passivation layer (180) and having a pixel opening (351) exposing the pixel electrode;
an organic emission layer (370) covering the pixel electrode (191); and
a common electrode (270) covering the organic emission layer (370) and the pixel definition layer (350),
wherein the pixel electrode (191) contacting the first wiring portion (171, 178) of the data wire and the interlayer insulating layer (160) has protrusions and depressions.

2. The organic light emitting diode display of claim 1, wherein the pixel electrode (191) includes a convex pixel portion (1911) contacting the first wiring portion of the data wire and a concave pixel portion (1912) contacting the interlayer insulating layer (160).

3. The organic light emitting diode display of claim 1 or 2, wherein:
the data wire includes a data line (171) for transmitting a data signal; and
the first wiring portion (171, 178) of the data wire includes the data line (171).

4. The organic light emitting diode display of claim 3, wherein:
the data wire further includes a dummy data member (178) insulated from the data line (171); and
the first wiring portion (171, 178) of the data wire includes the dummy data member (178).

5. The organic light emitting diode display of claim 4, further comprising an auxiliary electrode (192) on the passivation layer (180) and separated from the pixel electrode (191), wherein the auxiliary electrode (192) contacts the common electrode (270).

6. The organic light emitting diode display of claim 5, wherein the auxiliary electrode (192) is formed of the same material as the pixel electrode (191).

7. The organic light emitting diode display of claim 5 or 6, wherein:
the pixel definition layer (350) has an assistance opening (352) exposing the auxiliary electrode (192); and
the common electrode (270) contacts the auxiliary electrode (192) through the assistance opening (352).

8. The organic light emitting diode display of claim 7, wherein:
the data wire includes a second wiring portion (174) insulated from the data line (171); and
the auxiliary electrode (192) is connected to the second wiring portion (174) of the data wire through acontact hole (83) in the passivation layer (180).

9. The organic light emitting diode display of claim 8, wherein:
the gate wire includes a first storage electrode (127) overlapping the second wiring portion of the data wire; and
the second wiring portion of the data wire is a second storage electrode (174).

10. The organic light emitting diode display of claim 3, wherein:
the data wire further comprises a driving voltage line (172) for transmitting a driving voltage, a compensation control line (122) for transmitting a compensation control signal and crossing ascan line (121), an operation control line (123) crossing the scan line (121) and configured to transmit an operation control signal, and a reset control line (174) crossing the scan line and configured to transmit a reset signal; and
the first wiring portion of the data wire includes at least one of the driving voltage line, the compensation control line, the operation control line, and the reset control line.

11. The organic light emitting diode display of claim 10, further comprising an auxiliary electrode (192) on the passivation layer (180) and separated from the pixel electrode (191), and
wherein the auxiliary electrode contacts the common electrode (270).

12. The organic light emitting diode display of claim 11, wherein the auxiliary electrode (192) overlaps the driving voltage line (172).

13. The organic light emitting diode display of claim 11 or 12, wherein the auxiliary electrode (192) comprises the same material as the pixel electrode (191).

14. The organic light emitting diode display of any one of claims 10 to 13, wherein the gate wire further includes thescan line (121) transmitting a scan signal, and
wherein the organic light emitting diode display further comprises: a switching thin film transistor connected to the scan line (121) and the data line (171);
wherein a compensation thin film transistor is connected to the compensation control line (122);
wherein an operation control thin film transistor is connected to the operation control line (123) and the switching thin film transistor; and
wherein a driving thin film transistor is connected to the driving voltage line (172).
